# FASCICULE DE BREVET EUROPEEN

(11) **EP 0 479 679 B1**
(45) Date de publication et mention de la délivrance du brevet: **05.07.1995**
(21) Numéro de dépôt: 91402636.4
(22) Date de dépôt: 03.10.1991
(51) Int. Cl.: C23C 14/56

(54) **Procédé et installation de métallisation en continu d'une mèche de fibres étalée**
Verfahren und Vorrichtung zum kontinuierlichen Metallisieren eines ausgebreiteten Fiberbundels
Process and apparatus for continuous metallization of a spread fibre bundle

(30) Priorité: 05.10.1990 FR 9012314
(43) Date de publication de la demande: 08.04.1992
(73) Titulaire: AEROSPATIALE Société Nationale Industrielle, 75781 Paris Cédex 16 (FR)
(72) Inventeur: Goffetre, Gérard, F-92700 Colombes (FR); Renard, Pierre, F-91760 Itteville (FR)
(74) Mandataire: Poulin, Gérard

(56) Documents cités:
- EP-A- 0 134 559
- EP-A- 0 290 127
- US-A- 3 683 846
- CRYOGENICS, vol. 24, no. 11, 1 Novembre 1984, GUILFORD, UK, pp. 636-638; M. DIETRICH: "continous production of NbNon carbon fibres by magnetron sputtering"

## Description

L'invention concerne un procédé permettant d'effectuer en continu la métallisation d'une mèche de fibres, étalée dans le sens de sa largeur avant que cette mèche ne soit utilisée dans la fabrication d'un matériau composite à matrice métallique ou non métallique. L'invention concerne également une installation mettant en oeuvre ce procédé.

Pour fabriquer un matériau composite à matrice métallique, il est souhaitable de pouvoir revêtir en profondeur les méches de fibres utilisées dans ce matériau d'un métal identique à celui qui constitue la matrice métallique, afin de favoriser la pénétration du métal parmi les fibres lors de la fabrication ultérieure du matériau composite. Une métallisation préalable des fibres a aussi pour fonction d'éviter la diffusion du métal dans les fibres et, par conséquent, la fragilisation des fibres lorsque les mèches sont intégrées à la matrice métallique.

Par ailleurs, il peut aussi être avantageux de revêtir d'un métal de protection contre l'oxydation les mèches de fibres utilisées dans la fabrication des matériaux composites à matrice non métallique.

Dans le cas des mèches de fibres utilisées pour la fabrication des matériaux composites à matrice métallique, le métal à déposer sur les fibres est le métal constituant la matrice, c'est-à-dire généralement du magnésium, de l'aluminium, du titane, un alliage d'aluminium et de titane, etc.. Dans le cas où la mèche de fibres est destinée à fabriquer un matériau composite à matrice non métallique, notamment à base de céramique, une première couche barrière, peut être déposée sur les fibres, suivie d'une deuxième couche anti-oxydation.

Les fibres ainsi revêtues peuvent être de toute nature dans les deux cas, tels que des fibres de carbone, de carbure de silicium, ou autres.

Pour métalliser les fibres, on a déjà effectué des dépôts métalliques au chalumeau sur des mèches de fibres destinées à entrer dans la fabrication de matériaux composites. Cependant, cette technique a pour inconvénient que le métal ainsi déposé ne pénètre pas au coeur des mèches, de sorte que les fibres situées dans la partie centrale sont dépourvues de tout revêtement métallique.

Par ailleurs, il existe des mèches de fibres étalée sous forme de nappes et enroulées avec une feuille intercalaire, par exemple en aluminium, sur une bobine de stockage. Cependant, ces mèches de fibres étalée sont particulièrement fragiles et l'application d'un effort de traction sur la nappe formée par la mèche a pour effet de reformer cette dernière, de sorte que la métallisation de l'ensemble des fibres contenues dans la mèche constitue un problème particulièrement délicat à résoudre.

La présente invention a précisément pour objet un procédé de métallisation en continu dont les caractéristiques originales lui permettent d'assurer la métallisation d'une mèche de fibres étalée sans que celle-ci ne se reforme, de sorte que toutes les fibres constituant la mèche peuvent être revêtues de métal avant que la mèche ne soit utilisée dans la fabrication d'un matériau composite.

Selon l'invention, ce résultat est obtenu au moyen d'un procédé de métallisation en continu d'une mèche de fibres étalée, enroulée avec une première feuille intercalaire sur une bobine émettrice de mèche, caractérisé par le fait qu'il consiste à tirer en continu sur la feuille intercalaire, de façon à dérouler régulièrement la mèche de fibres étalée de la bobine émettrice de mèche et à faire défiler la mèche verticalement, par gravité, devant des moyens de métallisation.

En exerçant un effort de traction non pas sur la mèche, mais sur la feuille intercalaire et en laissant la mèche de fibres étalée défiler verticalement par gravité devant les moyens de métallisation, le procédé selon l'invention permet de maintenir la mèche sous sa forme étalée lors de sa métallisation, de sorte que toutes les fibres constituant la mèche sont enrobées régulièrement en continu et de façon contrôlée.

Avantageusement, on freine simultanément la bobine émettrice de mèche, pour éviter un déroulement excessif de la mèche de fibres étalée.

Par ailleurs, on tire sur la première feuille intercalaire en l'enroulant sur une bobine réceptrice d'intercalaire.

Dans un mode de réalisation préféré de l'invention, après avoir défilé devant les moyens de métallisation, la mèche de fibres étalée est réenroulée, avec une deuxième feuille intercalaire, sur une bobine réceptrice de mèche exerçant sur la mèche une tension au plus égale à une tension limite produisant un rétrécissement de largeur d'environ 10 % de la mèche.

Avantageusement, on place alors la deuxième feuille intercalaire sur une bobine émettrice d'intercalaire ayant un diamètre à vide au moins égal à un diamètre de remplissage maximum de la bobine réceptrice de mèche.

La métallisation de la mèche de fibres étalée en défilement vertical s'effectue avantageusement sous vide, selon la technique du dépôt physique en phase vapeur, par pulvérisation cathodique, au moyen de deux cathodes magnétron tournantes placées de part et d'autre de la mèche en défilement vertical.

L'invention a aussi pour objet une installation pour la mise en oeuvre de ce procédé.

Cette installation, permettant de métalliser en continu une mèche de fibres étalée enroulée avec une première feuille intercalaire sur une bobine émettrice de mèche, est caractérisée par le fait qu'elle comprend des moyens de traction aptes à tirer en continu sur la feuille intercalaire, de façon à dérouler régulièrement la mèche de fibres étalée de la bobine émettrice de mèche, et à faire défiler verticalement la mèche, par gravité, devant des moyens de métallisation.

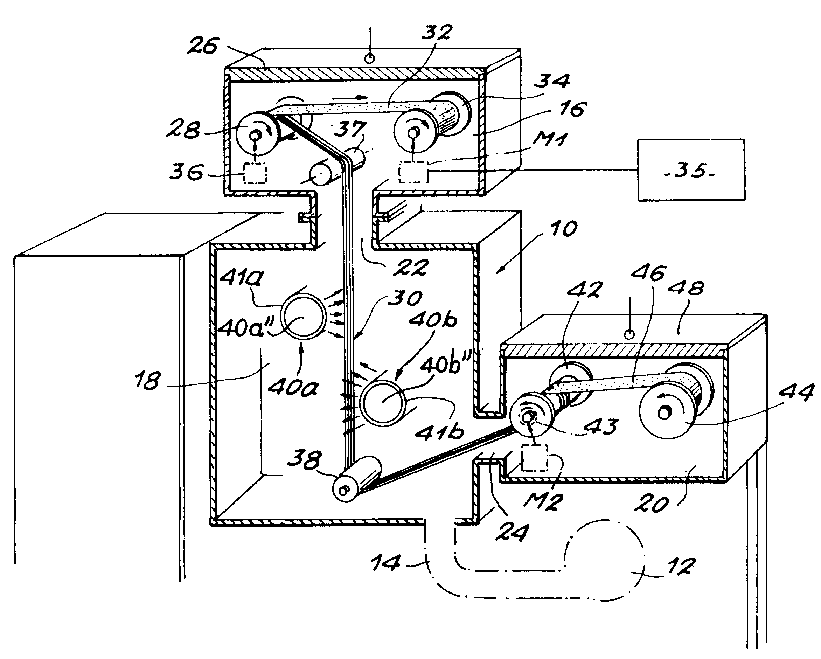

Un mode de réalisation préféré de l'invention va à présent être décrit, à titre d'exemple non limitatif, en se référant à la figure unique qui représente de façon schématique une installation de métallisation en continu conforme à l'invention.

Sur la figure, la référence 10 désigne une enceinte dont le volume intérieur peut être mis sous vide par l'actionnement d'une pompe à vide 12 communiquant avec l'enceinte par une canalisation 14.

De façon plus précise, l'enceinte sous vide 10 comporte une chambre 16 d'émission de la mèche de fibres étalée à métalliser, une chambre 18 de métallisation de cette mèche et une chambre 20 de réception de la mèche métallisée. La chambre 18 de métallisation est placée en dessous de la chambre 16 d'émission et communique avec cette dernière par un passage vertical 22. La chambre de réception 20 est placée quant à elle à côté de la partie inférieure de la chambre de métallisation 18 et communique avec cette dernière par un passage horizontal 24.

La chambre de distribution 16 est équipée, par exemple, d'un couvercle amovible 26 permettant de placer sur un premier axe horizontal au moins une bobine 28 émettrice de mèche. Sur chaque bobine 28 sont enroulées une mèche de fibres 30 étalée dans le-sens de sa largeur, et une feuille intercalaire 32 séparant chacune des couches formées par la mèche 30. Les fibres constituant la mèche 30 peuvent être d'une nature quelconque telle que du carbone, du carbure de silice ou autres, selon la nature du matériau composite à fabriquer. La largeur de la mèche étalée est, par exemple, d'environ 35 mm. La feuille intercalaire 32 peut notamment être réalisée en aluminium ou en polypropylène.

La chambre d'émission 16 contient un second axe parallèle à l'axe de la bobine émettrice de mèche 28, situé approximativement dans le même plan horizontal, et qui supporte autant de bobines 34 réceptrices d'intercalaire qu'il existe de bobines 28. Les bobines 34 sont entraînées en rotation par un moteur électrique M1 placé à l'intérieur de la chambre 16 et piloté par un micro-ordinateur 35.

Grâce à cette caractéristique, lorsque l'extrémité de la feuille intercalaire 32 est accrochée sur la bobine 34, la traction exercée sur la feuille intercalaire par l'entraînement en rotation de la bobine 34 a pour effet de dérouler la mèche de fibres étalée 30 sans qu'aucune force de traction ne soit exercée sur cette mèche. Le rétrécissement de la mèche étalée est ainsi évité.

Afin d'éviter un déroulement intempestif de la mèche de fibres étalée 30 et de la feuille intercalaire 32, un frein magnétique 36 est associé à la bobine 28.

La chambre d'émission 16 comprend enfin un galet libre de renvoi 37 dont l'axe est parallèle aux axes des bobines 28 et 34 et qui est placé au-dessus du passage vertical 22. En sortant de la bobine 28, la mèche de fibres étalée 30 passe sur le galet de renvoi 37, et descend verticalement par gravité dans le passage vertical 22 puis dans la chambre de métallisation 18, jusqu'à un second galet libre de renvoi 38, d'axe parallèle à l'axe du galet 37, placé dans le bas de la chambre de métallisation 18.

Dans la chambre de métallisation 18, la mèche de fibres étalée 30 défile verticalement entre deux cathodes magnétron tournantes 40a et 40b dont les axes de rotation sont parallèles aux axes des galets de renvoi 37 et 38 et placées à une même distance de part et d'autre de ladite mèche 30.

Chacune des cathodes magnétron 40a et 40b est constituée d'une partie fixe 40a˝, 40b˝, et d'une cible tournante 41a et 41b. Les cibles 41a et 41b sont réalisées en un métal correspondant au métal que l'on désire déposer sur les fibres constituant la mèche 30. La conception des cathodes magnétron tournantes est telle que le flux d'atomes couvre une zone (angle solide) déterminée par la position de ses aimants (non montrés).

Il est rappelé que la technique de la pulvérisation cathodique en courant continu consiste à appliquer entre une anode et une cathode un champ électrique intense qui a pour effet d'ioniser un gaz à basse pression tel que de l'argon. Les ions positifs de gaz bombardent la cathode, qui sert de cible, ce qui a pour effet de détacher de celle-ci des groupes d'atomes, qui passent ensuite dans la phase gazeuse et se déposent sur le substrat.

Dans les systèmes magnétron, un champ magnétique perpendiculaire au champ électrique précité est ajouté. Les électrons suivent alors un chemin hélicoïdal, ce qui augmente la probabilité de collisions ionisantes et, par conséquent, le nombre d'ions positifs de gaz formés et le rendement du système.

L'utilisation d'une cathode magnétron rotative a en outre pour avantage de conduire à une usure uniforme de la cible métallique.

Dans le mode de réalisation représenté sur la figure unique, les axes des cathodes magnétron 40a et 40b sont décalés verticalement l'un par rapport à l'autre. Cependant, ce décalage n'est pas obligatoire et il peut être réduit ou même supprimé dans certains cas.

Dans le bas de la chambre de métallisation 18, la mèche de fibres étalée 30 passe sur le galet de renvoi 38, puis traverse le passage horizontal 24 pour venir s'enrouler sur une bobine réceptrice de mèche 42, placée dans la chambre de réception 20 sur un axe orienté parallèlement aux axes des galets de renvoi 37 et 38 et aux axes des bobines 28 et 34.

La bobine 42 est entraînée en rotation dans le sens du rembobinage de la mèche de fibres métallisées 30 par un moteur électrique M2 tournant à une vitesse constante, légèrement supérieure à la vitesse maximale du moteur d'entraînement M1 de la bobine 34 réceptrice d'intercalaire. Un frein magnétique 43 à très faible couple (par exemple, environ 0,5 cm.N) est monté entre la bobine réceptrice 42 et son axe d'entraînement, de façon à maintenir la mèche de fibres métallisées légèrement tendue en permanence. Plus précisément, le couple du frein magnétique 43 associé à la bobine 42 est choisi afin que la tension appliquée sur la mèche lors de l'actionnement du moteur M2 soit au plus égale à une tension limite produisant un rétrécissement de largeur d'environ 10 % de la mèche étalée.

Un deuxième axe, placé dans la chambre de réception 20 parallèlement à l'axe de la bobine 42 et sensiblement dans le même plan horizontal que cet axe, supporte librement une bobine émettrice d'intercalaire 44. Une feuille intercalaire 46 enroulée sur cette bobine 44 est rembobinée sur la bobine 42 en même temps que la mèche de fibres métallisées 30, de façon à séparer les différentes couches de cette mèche. La feuille intercalaire 46 peut notamment être réalisée en aluminium ou en polypropylène.

Bien entendu, dans le cas où plusieurs mèches 30 issues de plusieurs bobines 28 sont métallisées simultanément dans la chambre 18, la chambre 20 contient autant de bobines 42 et 44 que nécessaire, placées sur les mêmes axes.

La bobine 44 émettrice d'intercalaire présente un diamètre à vide qui est au moins égal au diamètre de remplissage maximum de la bobine réceptrice de mèche 42. Cette caractéristique permet de limiter le couple de frottement de la feuille intercalaire 46 sur la bobine 42, en fin de rembobinage de la mèche de fibres métallisées, a une valeur suffisamment faible pour ne pas annuler le très faible couple exercé en sens inverse par la bobine 42 sur la mèche 30, lorsque le moteur M2 est actionné. Cela évite donc tout risque d'arrêt de la rotation de la bobine 42.

L'accès aux bobines 42 et 44 placées dans la chambre de récupération 20 est autorisé par un couvercle amovible 48 obturant normalement cette chambre.

Une porte pivotante (non représentée) supportant les cathodes magnétron 40a et 40b est en outre prévue dans la chambre de métallisation 18, afin de permettre aux opérateurs d'accéder à cette dernière, si nécessaire.

La vitesse de défilement de la bande devant les cathodes magnétron tournantes 40a et 40b est maintenue constante tout au long du traitement, grâce au micro-ordinateur 35 commandant le moteur électrique d'entraînement M1 de la bobine 34. Ce micro-ordinateur 35 est équipé d'un logiciel qui tient compte de la variation de diamètre de la feuille intercalaire 32 sur la bobine 34 au fur et à mesure du rembobinage ainsi que du foisonnement de la feuille intercalaire. Selon le cas, la vitesse de rotation du moteur peut être corrigée à chaque tour ou après un nombre déterminé de tours de la bobine 34.

Pour mettre en oeuvre l'appareil qui vient d'être décrit en se référant à la figure unique, les opérateurs accèdent aux chambres 16 et 20 en retirant respectivement les couvercles 26 et 48 et à la chambre 18 en ouvrant la porte (non représentée) d'accès à cette chambre. Les opérateurs peuvent alors mettre en place les différentes bobines, accrocher manuellement la feuille intercalaire 32 sur la bobine 34 et disposer manuellement la mèche de fibres étalée 30 sur les galets de renvoi 37 et 38, avant de l'accrocher sur la bobine 42 avec la feuille intercalaire 46.

Lorsque ces différentes opérations d'initialisation du procédé ont été effectuées, les couvercles 26 et 48 sont remis en place et la porte d'accès à la chambre de métallisation 18 est fermée. Le vide nécessaire au dépôt physique en phase vapeur du métal constituant les cathodes 40a et 40b sur la mèche de fibres étalée est ensuite réalisé dans l'enceinte 10, à l'aide de la pompe à vide 12 et un gaz tel que de l'argon est injecté par une canalisation (non représentée).

Dès qu'un vide suffisant est atteint, le défilement de la mèche de fibres étalée devant les cathodes magnétron tournantes 40a et 40b est déclenché en actionnant le moteur électrique M1 commandant la rotation de la bobine 34. Simultanément, le moteur électrique M2 servant à entraîner en rotation la bobine 42 par l'intermédiaire du frein magnétique 43 est également actionné. En outre, les cathodes magnétron rotatives 40a et 40b sont mises sous tension et entraînées en rotation à vitesse constante, de façon à effectuer un dépôt par pulvérisation cathodique du métal constituant les cibles sur chacune des faces de la mèche de fibres étalée.

Etant donné que la mèche 30 défile en continu et à vitesse constante devant les cathodes magnétron tournantes 40a, 40b pratiquement sans qu'aucune force de traction ne lui soit appliquée, on réalise ainsi un dépôt métallique uniforme sur toutes les fibres constituant la mèche.

Par ailleurs, la technique utilisée pour rembobiner la mèche métallisée permet de minimiser l'effort appliqué sur cette dernière tout en assurant le dévidement de la feuille intercalaire 46. En particulier, l'utilisation d'un frein magnétique 43 à faible couple, constant sur toute la périphérie du frein, permet d'appliquer une tension constante et très faible sur la mèche métallisée, la bobine 42 n'étant plus entraînée par le moteur électrique en cas de dépassement du couple. Par ailleurs, la tension exercée sur la mèche métallisée est également limitée par l'utilisation d'une bobine 44 dont le diamètre est relativement grand par rapport à celui de la bobine 42, ce qui permet de réduire au minimum la tension nécessaire à l'entraînement de la feuille intercalaire 46.

Des essais effectués à l'aide de l'appareil illustré sur la figure unique ont permis de montrer qu'un dépôt homogène peut être obtenu, dans la mesure où les fibres constituant la mèche 30 sont parfaitement étalée et non torsadées.

Des essais ont notamment été effectués avec une puissance électrique de 3 kW, sous un vide maximum de 4.10⁻⁶ millibars et une pression d'argon de 6.10⁻³ millibars, la vitesse de défilement de la mèche étant d'environ 7 m/h et les cathodes tournant à environ 6 t/min. Ces essais ont conduit à un dépôt métallique homogène formant une colonne entourant chacune des fibres des mèches traitées.

Bien entendu, l'invention n'est pas limitée au mode de réalisation qui vient d'être décrit à titre d'exemple, mais en couvre toutes les variantes. On comprendra notamment que les cathodes magnétron tournantes 40a et 40b, qui permettent dans l'exemple décrit d'assurer le dépôt métallique sur les fibres, peuvent être remplacées par d'autres moyens de dépôt connus tels que des cathodes magnétron planes et fixes, sans sortir du cadre de l'invention.

## Revendications

1. Procédé de métallisation en continu d'une mèche de fibres étalée (30), enroulée avec une première feuille intercalaire (32) sur une bobine émettrice de mèche (28), caractérisé par le fait qu'il consiste à tirer en continu sur la feuille intercalaire (32), de façon à dérouler régulièrement la mèche de fibres étalée (30) de la bobine émettrice de mèche (28) et à faire défiler la mèche verticalement, par gravité, devant des moyens de métallisation (40a,40b).

2. Procédé selon la revendication 1, caractérisé par le fait qu'on freine simultanément la bobine émettrice de mèche (28), pour éviter un déroulement excessif de la mèche de fibres étalée (30).

3. Procédé selon l'une quelconque des revendications 1 et 2, caractérisé par le fait qu'après avoir défilé devant les moyens de métallisation (40a,40b), la mèche de fibres étalée (30) est réenroulée, avec une deuxième feuille intercalaire (46) sur une bobine réceptrice de mèche (42) exerçant sur la mèche une tension au plus égale à une tension limite produisant un rétrécissement de longueur d'environ 10 % de la mèche.

4. Procédé selon la revendication 3, caractérisé par le fait qu'on place la deuxième feuille intercalaire (46) sur une bobine émettrice d'intercalaire (44) ayant un diamètre à vide au moins égal à un diamètre de remplissage maximum de la bobine réceptrice de mèche (42).

5. Procédé selon l'une quelconque des revendications précédentes, caractérisé par le fait qu'on tire sur la première feuille intercalaire (32) en l'enroulant sur une bobine réceptrice d'intercalaire (34) tournant à une vitesse contrôlée, de façon à faire défiler la mèche verticalement à vitesse constante.

6. Procédé selon l'une quelconque des revendications précédentes, caractérisé par le fait qu'on effectue la métallisation de la mèche de fibres étalée (30) en défilement vertical, sous vide, par dépôt physique en phase vapeur.

7. Installation de métallisation en continu d'une mèche de fibres étalée (30) enroulée avec une première feuille intercalaire (32) sur une bobine émettrice de mèche (28), caractérisée par le fait qu'elle comprend des moyens de traction (34) aptes à tirer en continu sur la feuille intercalaire, de façon à dérouler régulièrement la mèche de fibres étalée (30) de la bobine émettrice de mèche (28), et à faire défiler verticalement la mèche, par gravité, devant des moyens de métallisation (40a,40b).

8. Installation selon la revendication 7, caractérisée par le fait que les moyens de traction comprennent une bobine réceptrice d'intercalaire (34) et des moyens (M1) d'entraînement en rotation de cette dernière à une vitesse contrôlée assurant un déroulement de la mèche (30) à vitesse constante.

9. Installation selon l'une quelconque des revendications 7 et 8, caractérisée par le fait que la bobine émettrice de mèche (28) est équipée de moyens de freinage (36).

10. Installation selon l'une quelconque des revendications 7 à 9, caractérisée par le fait qu'elle comprend de plus une bobine réceptrice de mèche (42), sur laquelle la mèche de fibres étalée est réenroulée, après avoir défilé devant les moyens de métallisation (40a,40b), sous l'action de moyens (M2, 43) d'entraînement en rotation de la bobine réceptrice de mèche, exerçant sur la mèche une tension au plus égale à une tension limite produisant un rétrécissement de largeur d'environ 10 % de la mèche.

11. Installation selon la revendication 10, caractérisée par le fait qu'elle comprend de plus une bobine émettrice d'intercalaire (44) associée à la bobine réceptrice de mèche (42), la bobine émettrice d'intercalaire ayant un diamètre à vide au moins égal à un diamètre de remplissage maximum de la bobine réceptrice de mèche.

12. Installation selon l'une quelconque des revendications 10 et 11, caractérisée par le fait que les moyens d'entraînement en rotation de la bobine réceptrice de mèche (42) comprennent un moteur (M2) apte à être actionné à une vitesse constante au moins égale à la vitesse de déroulement de la mèche (30), et des moyens de freinage (43) interposés entre le moteur (M2) et la bobine réceptrice de mèche (42).

13. Installation selon l'une quelconque des revendications 7 à 12, caractérisée par le fait qu'elle comprend une enceinte sous vide (10) contenant la bobine émettrice de mèche (28), les moyens de traction (34), et les moyens de métallisation, ces derniers moyens comprenant au moins deux dispositifs de dépôt par pulvérisation cathodique (40a,40b), places de part et d'autre de la mèche en défilement vertical.

14. Installation selon la revendication 12, caractérisée par le fait que les dispositifs de dépôt par pulvérisation cathodique sont des cathodes magnétron tournantes (40a,40b).

## Claims

1. Process for the continuous metallization of a spread fibre sliver (30), wound with a first interpolated sheet (32) onto a sliver supply spool (28), characterized in that the process consists of continuously pulling on the interpolated sheet (32), so as to regularly unwind the spread fibre sliver (30) from the sliver supply spool (28) and make the sliver travel vertically by gravity in front of the metallization means (40a,40b).

2. Process according to claim 1, characterized in that the sliver supply spool (28) is simultaneously decelerated in order to prevent an excessive unwinding of the spread fibre sliver (30).

3. Process according to claim 1 or 2, characterized in that after passing in front of the metallization means (40a, 40b), the spread fibre sliver (30) is rewound, with a second interpolated sheet (46) onto a sliver reception spool (42) exerting on the said sliver a tension which is at the most equal to a limit tension producing a width reduction of approximately 10% on the part of the sliver.

4. Process according to claim 3, characterized in that the second interpolated sheet (46) is placed on an interpolated sheet supply spool (44) having an empty diameter at least equal to the maximum filling diameter of the sliver reception spool (42).

5. Process according to any one of the preceding claims, characterized in that pulling takes place on the first interpolated sheet (32) on winding it onto an interpolated sheet receiving spool (34) rotating at a controlled speed, so that the sliver travels vertically at a constant speed.

6. Process according to any one of the preceding claims, characterized in that the metallization of the vertically travelling spread fibre sliver (30) takes place in vacuo by physical vapour phase deposition.

7. Installation for the continuous metallization of a spread fibre sliver (30) wound with a first interpolated sheet (32) onto a sliver supply spool (28), characterized in that it comprises tensioning means (34) able to continuously pull on the interpolated sheet, so as to regularly unwind the spread fibre sliver (30) from the sliver supply spool (28) and make the sliver travel vertically by gravity in front of the metallization means (40a,40b).

8. Installation according to claim 7, characterized in that the tensioning means incorporate an interpolated sheet receiving spool (34) and means (M1) for rotating the latter at a controlled speed ensuring an unwinding of the sliver (30) at a constant speed.

9. Installation according to any one of the preceding claims, characterized in that the sliver supply spool (28) is equipped with braking means (36).

10. Installation according to any one of the claims 7 to 9, characterized in that said installation also comprises a sliver reception spool (42), onto which the spread fibre sliver is rewound, after travelling in front of the metallization means (40a,40b), under the action of means (M2,43) for rotating the sliver reception spool, exerting on the sliver a tension at the most equal to the limit tension producing a width reduction of approximately 10% on the part of the sliver.

11. Installation according to claim 10, characterized in that said installation also comprises an interpolated sheet supply spool (44) associated with the sliver reception spool (42), the interpolated sheet supply spool having an empty diameter at least equal to the maximum filling diameter of the sliver reception spool.

12. Installation according to claim 10 or 11, characterized in that the means for rotating the sliver reception spool (42) incorporate a motor (M2) which can be operated at a constant speed at least equal to the sliver (30) unwinding speed, as well as braking means (43) interposed between the motor (M2) and the sliver reception spool (42).

13. Installation according to any one of the claims 7 to 12, characterized in that it comprises a vacuum enclosure (10) containing the sliver supply spool (28), the tensioning means (34) and the metallization means, said latter means incorporating at least two cathodic sputtering deposition devices (40a,40b) placed on either side of the vertically travelling sliver.

14. Installation according to claim 12, characterized in that the cathodic sputtering deposition devices are rotary magnetron cathodes (40a,40b).

## Patentansprüche

1. Verfahren zum kontinuierlichen Metallisieren eines ausgebreiteten Fiberbündels (30), das mit einer ersten Zwischenfolie (32) auf einer Vorratsspule (28) aufgerollt ist, **gekennzeichnet durch** ein kontinierliches Ziehen an der Zwischenfolie (32) in der Weise, daß das ausgebreitete Fiberbündel (30) von der Vorratsspule (28) gleichmäßig abspult, und ein vertikales Vorbeilaufenlassen des Bündels vor einer Metallisierungseinrichtung (40a,40b) mittels der Schwerkraft.

2. Verfahren nach Anspruch 1, **dadurch gekennzeichnet, daß** die Vorratsspule (28) gleichzeitig abgebremst wird, um ein zu starkes Abspulen des ausgebreiteten Fiberbündels (30) zu vermeiden.

3. Verfahren nach einem der Ansprüche 1 und 2, **dadurch gekennzeichnet, daß** das ausgebreitete Fiberbündel (30) nach dem Vorbeilaufen vor der Metallisierungseinrichtung (40a,40b) mit einer zweiten Zwischenfolie (46) auf einer Aufnahmespule (42) aufgerollt wird, welche auf das Bündel eine Spannung ausübt, die höchstens gleich groß wie eine Grenzspannung ist, welche eine Längendehnung von ungefähr 10 % des Bündels erzeugt.

4. Verfahren nach Anspruch 3, **dadurch gekennzeichnet, daß** die zweite Zwischenfolie (46) auf einer Zwischenvorratsrolle (44) angeordnet wird, die einen Leerdurchmesser mindestens gleich einem maximalen Volldurchmesser der Aufnahmespule (42) aufweist.

5. Verfahren nach einem der vorangegangenen Ansprüche, **dadurch gekennzeichnet, daß** an der ersten Zwischenfolie (32) beim Einrollen auf eine Zwischenaufnahmespule (34) gezogen wird, welche sich mit einer gesteuerten Geschwindigkeit dreht in der Weise, daß das Bündel mit einer konstanten Geschwindigkeit vertikal vorbeiläuft.

6. Verfahren nach einem der vorangegangenen Ansprüche, **dadurch gekennzeichnet, daß** die Metallisierung des ausgebreiteten Fiberbündels (30) beim vertikalen Vorbeilaufen unter Vakuum durch physikalische Dampfphasenablagerung vollzogen wird.

7. Vorrichtung zum kontinuierlichen Metallisieren eines ausgebreiteten Fiberbündels (30), das mit einer ersten Zwischenfolie (32) auf einer Vorratsspule (28) aufgerollt ist, **dadurch gekennzeichnet, daß** sie eine Zugeinrichtung (24) umfaßt, mit der kontinuierlich an der Zwischenfolie gezogen werden kann in der Weise, daß das ausgebreitete Fiberbündel (30) von der Vorratsspule (28) gleichmäßig abgespult wird, und mit der das Bündel durch Schwerkraft an einer Metallisierungseinrichtung (40a,40b) vorbeilaufen gelassen werden kann.

8. Vorrichtung nach Anspruch 7, **dadurch gekennzeichnet, daß** die Zugeinrichtungen eine Zwischenaufnahmenspule (34) und eine Mitnahmeeinrichtung (M1) umfassen, wobei die Drehung des letzteren mit einer gesteuerten Geschwindigkeit geschieht, welche ein Abspulen des Bündels (30) bei konstanter Geschwindigkeit sicherstellt.

9. Vorrichtung nach einem der Ansprüche 7 und 8, **dadurch gekennzeichnet, daß** die Vorratsspule (28) mit einer Bremseinrichtung (36) versehen ist.

10. Vorrichtung nach einem der Ansprüche 7 - 9, **dadurch gekennzeichnet, daß** sie außerdem eine Aufnahmespule (42) umfaßt, auf welche das ausgebreitete Fiberbündel aufgerollt ist, nachdem es vor der Metallisierungseinrichtung (40a,40b) unter Einwirkung der Einrichtung (M2,43) zum Drehantrieb der Aufnahmespule vorbeigelaufen ist, wobei auf das Bündel eine Spannung ausgeübt wird, die höchstens gleich groß wie eine Grenzspannung ist, die eine Längendehnung von ungefähr 10 % des Bündels erzeugt.

11. Vorrichtung nach Anspruch 10, **dadurch gekennzeichnet, daß** sie außerdem eine Zwischenvorratsspule (44) umfaßt, die mit der Aufnahmespule (42) verbunden ist, wobei die Zwischenvorratsspule einen Leerdurchmesser aufweist, der mindestens gleich einem maximalen Volldurchmesser der Aufnahmespule ist.

12. Vorrichtung nach einem der Ansprüche 10 und 11, **dadurch gekennzeichnet, daß** die Einrichtung zum Drehantrieb der Aufnahmespule (42) einen Motor (M2), welcher mit einer konstanten Geschwindigkeit mindestens gleich der Abrollgeschwindigkeit des Bündels (30) betrieben werden kann und eine Bremseinrichtung (43) umfaßt, die zwischen dem Motor (M2) und der Aufnahmespule (42) angeordnet ist.

13. Vorrichtung nach einem der Ansprüche 7 - 12, **dadurch gekennzeichnet, daß** sie ein Vakuumgehäuse (10) umfaßt, welches die Vorratsspule (28), die Zugeinrichtung (34) und die Metallisierungseinrichtung enthält, wobei die letztere Einrichtung mindestens zwei Vorrichtungen zur kathodischen Zerstäuberablagerung (40a,40b) umfaßt, die beiderseitig des vertikalvorbeilaufenden Bündels angeordnet sind.

14. Vorrichtung nach Anspruch 12, **dadurch gekennzeichnet, daß** die Vorrichtung zur kathodischen Zerstäuberablagerung drehende Magnetrollenkathoden (40a,40b) sind.
